# EUROPEAN PATENT SPECIFICATION

(11) **EP 3 177 034 B1**
(45) Date of publication and mention of the grant of the patent: **11.10.2023**
(21) Application number: 15197961.4
(22) Date of filing: 04.12.2015
(51) Int. Cl.: H04R 1/24, H04R 3/00, H04R 29/00

(54) **AUDIO PROCESSING SYSTEM FOR TEMPERATURE ESTIMATION OF MULTIPLE LOUDSPEAKERS**
AUDIOVERARBEITUNGSSYSTEM ZUR TEMPERATURBESTIMMUNG MEHRERER LAUTSPRECHER
SYSTÈME DE TRAITEMENT AUDIO POUR L'ESTIMATION DE LA TEMPERATURE DE PLUSIEURS HAUT-PARLEURS

(43) Date of publication of application: 07.06.2017
(73) Proprietor: NXP B.V., 5656 AG Eindhoven (NL)
(72) Inventor: GAUTAMA, Temujin, Redhill, Surrey RH1 1SH (GB)
(74) Representative: Schmütz, Christian Klaus Johannes

(56) References cited:
- EP-A1- 1 799 013
- US-A1- 2002 118 841
- US-A1- 2011 194 705
- US-A1- 2013 329 898

## Description

This disclosure relates to an audio processing system for multiple-loudspeakers.

Loudspeakers are devices that convert electrical energy into acoustical energy. However, much of the electrical power that is applied to the loudspeaker results in heat dissipation, which causes many of the common loudspeaker defects. In order to prevent thermal damage (permanent or temporary), it is desirable to condition the input signal in such a way that the temperature does not exceed a certain limit.

Multi-way loudspeakers for example consisting of a bass, mid-range loudspeaker and a tweeter may be used to cover the complete audio spectrum. Multi-way loudspeakers typically use separate amplifiers for each speaker since each speaker typically has very different characteristics and drive requirements.

US 2002/118841 A1 describes a system for using digital signal processing to compensate for power compression of loudspeakers. US 2013/329898 A1 describes speaker temperature control using speaker temperature and speaker impedance estimates. EP 1799013A1 describes a method and system for predicting the behaviour of a transducer. US2011/194705A1 describes a system and method for adapting a loudspeaker signal.

Various aspects are defined in the accompanying claims. In a first aspect there is defined an audio processing system for a multi-speaker system according to claim 1.

The multi-speaker system may be included in a music system in a motor vehicle.

In a second aspect, there is described a method of controlling a multi-speaker system according to claim 11.

Preferred embodiments are defined in the dependent claims.

There may be provided a computer program, which when run on a computer, causes the computer to configure any apparatus, including a circuit, controller, sensor, filter, or device disclosed herein or perform any method disclosed herein. The computer program may be a software implementation, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software implementation may be an assembly program.

The computer program may be provided on a computer readable medium, which may be a physical computer readable medium, such as a disc or a memory device, or may be embodied as a transient signal. Such a transient signal may be a network download, including an internet download.

In the figures and description like reference numerals refer to like features.

Embodiments are now described in detail, by way of example only, illustrated by the accompanying drawings in which:
Figure 1 shows an audio processing system according to an embodiment.
Figure 2 illustrates a graph of an example frequency response of a speaker and a further speaker.
Figure 3 shows an audio processing system according to an embodiment.
Figure 4 illustrates an audio processing system according to an embodiment.
Figure 5 shows an audio processing system according to an embodiment.
Figure 6 illustrates an audio processor for inclusion in one or more embodiments of an audio processing system.
Figure 7 an audio processor for inclusion in one or more embodiments of an audio processing system.
Figure 8 illustrates an example filter response of an audio processor of figure 7.
Figure 9 shows a method of audio processing system for a multi speaker system.

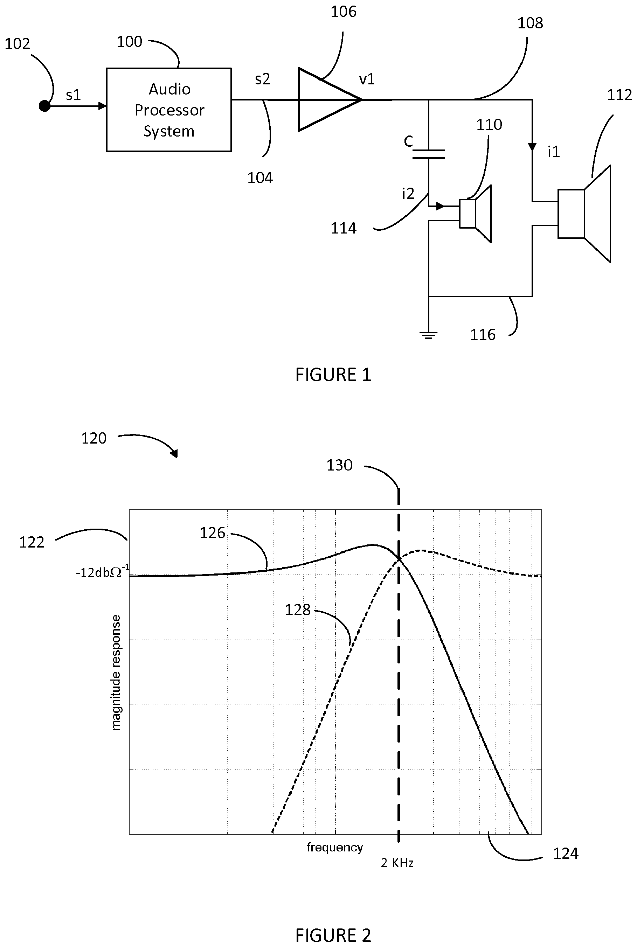

Figure 1 shows an audio processing system 100 having an audio input 102, and an audio output 104. The audio output 104 may be connected to an input of an audio amplifier 106, which may for example be a class D audio amplifier. The output 108 of the audio amplifier 106 may be connected to a first speaker 112 which may be a mid-range loudspeaker. The output 108 of the audio amplifier 106 may be connected to a first terminal of a capacitor C. A second terminal of capacitor C may have connection 114 to a second speaker 110 which may be a high-range loudspeaker or tweeter. The first speaker 112 and the second speaker 110 may also have a ground connection 116. The arrangement of the first speaker 112 the second speaker 110 may be referred to as a multi-way speaker system.

In operation, an audio signal which may be denoted s1 may be processed by the audio processor system 100. The audio processor system 100 may output a processed audio signal s2 on the audio processor output 104. The amplifier 106 may amplify the processed audio signal s2 resulting in a signal of voltage v1. The respective currents flowing into the parallel branches are i1 and i2. The full-band output signal applied to the first loudspeaker 112, and the output signal may be high-pass filtered in the second parallel branch by the capacitor C, such that the second loudspeaker 110 does not receive the low frequencies. As will be appreciated, the currents i1 and i2 may be alternating currents due to the audio signal and may be referred to as signal currents. A full-band output signal may for example include frequencies in the range between 0 Hz and 24 KHz. Low frequencies may be for example frequencies below 2 KHz. The two loudspeakers 112,110 may have currents i1 and i2 flowing into their voice coils and dissipating power, which results in heating of the voice coils. The heating of the two loudspeakers 112,110 may be different, because they receive different currents and because they are different in design. For each of the loudspeakers in the multi-way loudspeaker system, the voice coil temperature is estimated by the audio processing system 100, using a thermal loudspeaker model. In this particular two-way system, two voice coil temperatures can be obtained, T1 and T2, respectively of the first loudspeaker 112 and the second loudspeaker 110. The temperatures are related to the currents flowing into the voice coils, i1 and i2.

If the amplifier 106 operates in its linear regime, v1 is a scaled version of s2. Furthermore, assuming linearity of the components C, the first speaker 112 and the second speaker 110, the currents i1 and i2 are linearly filtered versions of s2. The voice coil temperatures can be controlled by controlling the signal powers of i1 and i2.

The currents i1 and i2 can be estimated from the electrical circuit, i.e., the complete amplifier load, and either the measured total current that flows into the load corresponding to i1 + i2 , or the output voltage signal v1 .

Referring now to figure 2 which shows a graph 120 of an example magnitude response of output voltage to current on the y axis 122 against frequency on the x axis 124. Graph line 126 shows the transfer function of the amplifier output voltage v1 to first speaker current i1 having an initial magnitude response value at 0 Hz of -12 dBΩ⁻¹. Graph line 128 shows the transfer function of the amplifier output voltage v1 to i2. The first speaker current, i1, shows a lowpass filter characteristic and the second speaker current, i2, shows a high-pass filter characteristic. The inventor of the present disclosure has realised that the temperatures of the loudspeaker voice coils can be influenced by selectively modifying the signal powers in the frequency regions which correspond to the 'passbands' of the amplifier voltage output-to-current transfer functions. For example, the temperature of the voice coil of the first speaker 112 may be influenced by modifying the signal power in the lower frequency region which may include frequencies below the cross-over frequency indicated by line 130. In this example, the cross-over frequency 130 is a frequency of 2 KHz. In other examples the cross-over frequency may be for example in the range of 2 to 3 KHz. Similarly the temperature of the voice coil of the second speaker 110 may for example be influenced by modifying the signal power in the upper frequency region which may include frequencies above the cross-over frequency indicated by line 130. These frequency regions do not need to be defined by a single frequency. In other examples the lower and upper frequency regions can be overlapping. In other examples the speakers may have multiple passbands, the speakers may have more than one resonant frequency

Referring back to figure 1, the audio processor system 100 may determine a temperature value for each of the first speaker 110 and the second speaker 112 for example by estimation from a model of the amplifier and the speaker circuit or from a voltage or current measurement. The audio processor system 100 alters the amplitude of one or more frequencies of the audio signal within frequency regions corresponding to the speaker passbands of the first speaker 112 and the second speaker 110 in response to the temperature values T1 and T2 for the respective first speaker 112 and the second speaker 110. The audio processor system 100 may for example attenuate one or more frequencies within the speaker passband if the temperature value exceeds a predetermined threshold. Alternatively or in addition the audio processor 100 may amplify signals in selective frequency regions if the temperature value of either T1 or T2 indicates that the respective speaker voice coil temperature is low and therefore the signal may be boosted without damaging the speaker. The audio processor system 100 may enable a multiway speaker system to be driven from a single amplifier 106 while maintaining audio quality and ensuring that the different speakers in a multiway speaker system are not damaged by being for example overdriven.

The skilled person will appreciate that the voice coil temperature may be estimated based on a number of pre-estimated parameters starting from the electrical signal that is sent to the loudspeaker. Other methods may use a tone at an evaluation frequency to estimate the magnitude of the electrical impedance and compute the voice coil temperature from this evaluation frequency.

Voice coil temperature may be typically controlled by applying an attenuation to the source signal, by for example applying a gain factor that is related to inverse of the voice coil temperature variation in time or controlling a signal attenuator to the input signal.

The audio processing system 100 may be implemented in hardware, software, or a combination of hardware and software. For example, the audio processor system may be implemented by software modules running on a digital signal processor. Alternatively, the audio processor system 100 may be implemented by hardware logic circuits.

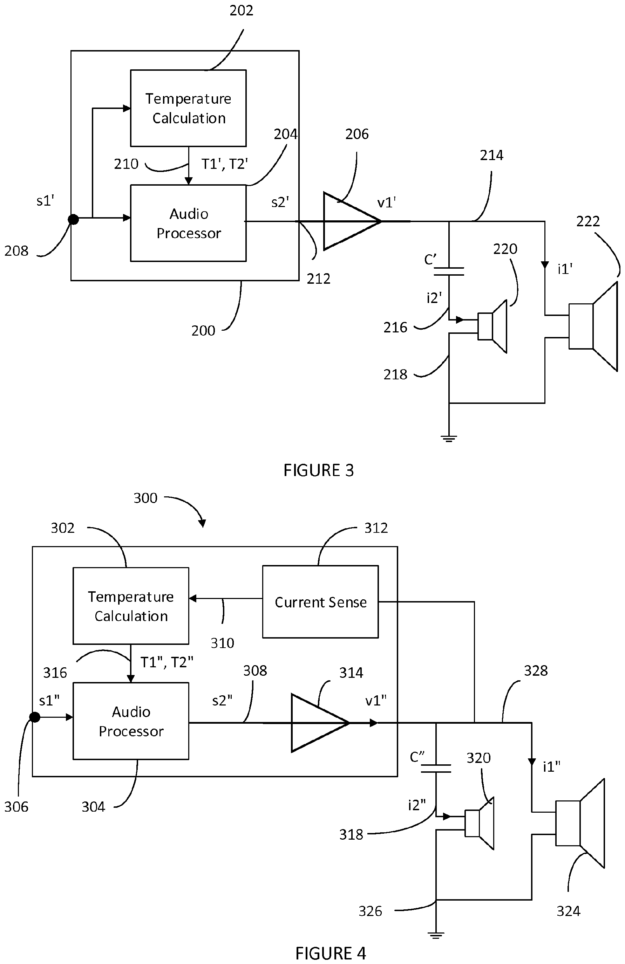

Figure 3 shows an example audio processing system 200. The audio processing system may include an audio processor 204 and a temperature calculation module 202. The audio processor 204 may be connected to an audio processing system input 208. An output 212 of the audio processor 204 may be connected to the input of a speaker amplifier 206 which may be for example a Class-D audio amplifier. The audio processing system input 208 may be connected to an input of the temperature calculation module 202. An output of the temperature calculation module 210 may be connected to the audio processor 204.

The audio processor 204, and the temperature calculation module 202 may be implemented in hardware, software, or a combination of hardware and software. The skilled person will appreciate that the speaker amplifier 206 may be implemented in hardware.

The audio processing system 200 may drive a multiway speaker network including a first speaker 222, a second speaker 220, and a capacitor C'. An output 214 of the amplifier 206 may be connected to a first terminal of the capacitor C and a first terminal of the first speaker 222. A second terminal of the first speaker may be connected to a ground 218. The second terminal of the capacitor C may have a connection 216 to a first terminal of the second speaker 220. The second terminal of the second speaker 220 may be connected to a ground potential 218.

In operation, an audio input signal s1' may be input into the temperature calculation module 202 and the audio processor 204. The temperature calculation module 202 may include a predictive model accounting for the behaviour of the amplifier 206 and the speaker network including the first speaker 222 second speaker 220, and the capacitor C. A predictive model may include a model of the input-output transfer function of the amplifier 206 and the amplifier-output-voltage-to-current transfer function for each of the first speaker 222 and the second speaker 220. From the predictive model, the temperature calculation module 202 determines an estimate of the expected temperature T 1' of the voice coil of the first speaker 222. From the predictive model, the temperature calculation module 202 determines an estimate of the expected temperature T2' of the voice coil of the second speaker 220. The temperature calculation module 202 outputs an expected value of voice coil temperature T1' of the first speaker 222. The temperature calculation module 202 outputs an expected value of voice coil temperature T2' of the second speaker 220. The audio processor 204 alters the amplitude, or signal energy in selective frequency bands dependent on the temperature value calculated for the first speaker 222, and the second speaker 220.

The audio processor 204 may for example attenuate one or more frequencies within the speaker passband if the temperature value exceeds a predetermined threshold. Alternatively or in addition the audio processor 204 may amplify signals in selective frequency regions if the temperature value of either T1' or T2' indicates that the respective speaker voice coil temperature is low and therefore the signal may be boosted without damaging the speaker. The processed output signal s2' may be amplified by the audio amplifier 206. The voltage output of the amplifier v1' may result in a current i1' in the voice coil of the first speaker 222 and a current i2' in the voice coil of the second speaker 220. By altering the amplitude or signal energy in selective frequency bands, the audio processing system 200 may predominantly control the currents flowing through the first speaker 222 and the second speaker 220 separately. The audio processor system 200 may enable a multiway speaker system to be driven from a single amplifier 206 while maintaining audio quality and ensuring that the different speakers in a multiway speaker system are not damaged by for example overheating.

Figure 4 shows an example audio processing system 300. The audio processing system 300 may include an audio processor 304, a temperature calculation module 302, a current sensor 312, and a speaker amplifier 314. The audio processor 304 may be connected to an audio processing system input 306. An output 308 of the audio processor 304 may be connected to the input of the speaker amplifier 314 which may be for example a Class-D audio amplifier. A current sensor output 310 may be connected to the temperature calculation module 302. An output 316 of the temperature calculation module 302 may be connected to the audio processor 304.

The audio processor 304 and/or the temperature calculation module 302 may be implemented in hardware, software or a combination of hardware and software. The current sensor 312 may be implemented in hardware or a combination of hardware and software. The speaker amplifier 314 may be implemented in hardware.

The audio processing system 300 may drive a multiway speaker network including a first speaker 324, a second speaker 320, and a capacitor C". The output 328 of the amplifier 314 may have a connection 318 to a first terminal of the capacitor C" and a first terminal of the first speaker 324. A second terminal of the first speaker may be connected to a ground 326. The second terminal of the capacitor C" may be connected to a first terminal of the second speaker 320. The second terminal of the second speaker 320 may be connected to a ground potential 326.

In operation, the current sensor 312 may have an input connected to the output 328 of the amplifier 314. An audio input signal s1" may be input into the audio processor 304. The temperature calculation module 302 may include a circuit model of the speaker network including the first speaker 324, second speaker 320, and the capacitor C". The temperature calculation module 302 may determine a temperature T1" of the voice coil of the first speaker 324 and the temperature T2" of the voice coil of the second speaker 320 from the current sensed by the current sensor. For example the current sensor 312 may directly determine a value of v1" and i1" and the temperature calculation module 302 may determine a value of voice coil temperature T1" of the first speaker 324 from the current i1". The temperature calculation module 302 may determine a value of the voice coil temperature T2" of the second speaker 320 by deriving a value of the current i2" from v1". The audio processor 304 alters the amplitude, or signal energy in selective frequency regions corresponding to the speaker passbands of the first speaker 324 and the second speaker 320 in response to the temperature values T1" and T2" for the respective first speaker 324 and the second speaker 320. The audio processor 304 may for example attenuate one or more frequencies within the speaker passband if the temperature value exceeds a predetermined threshold. Alternatively or in addition the audio processor 304 may amplify signals in selective frequency regions if the temperature value of either T1" or T2" indicates that the respective speaker voice coil temperature is low and therefore the signal may be boosted in certain frequencies without damaging the speaker. The processed output signal s2" may be amplified by the audio speaker amplifier 314. The voltage output of the amplifier v1" may result in a current i1" in the voice coil of the first speaker 324 and a current i2" in the voice coil of the second speaker 320. By altering the amplitude or signal energy in selective frequency bands, the audio processing system 300 may predominantly control the currents flowing through the first speaker 324 and the second speaker 320 separately. The audio processor system 300 may enable a multiway speaker system to be driven from a single amplifier 314 while maintaining audio quality and ensuring that the different speakers in a multiway speaker system are not damaged by being for example overdriven.

In an alternative example, the audio processor may generate one or more evaluation frequencies at constant amplitude which may be detected by the current sensor. The attenuation of the evaluation frequencies may be used to determine the impedance of the loudspeaker coil which as the skilled person will appreciate may then be used to determine a temperature value. The audio processor may generate different evaluation frequencies within the passbands of the different speakers so that the impedance values may be independently determined.

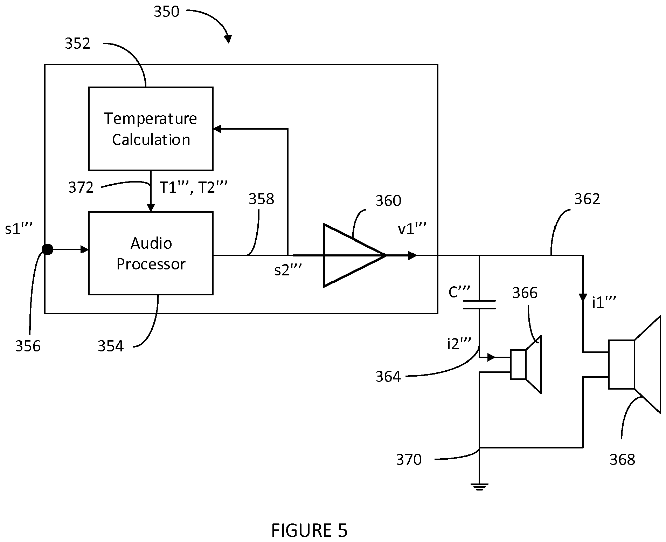

Figure 5 illustrates an example audio processing system 350. The audio processing system 350 may include an audio processor 354, a temperature calculation module 352, and a speaker amplifier 360. The audio processor 354 may be connected to an audio processing system input 356. An output 358 of the audio processor 354 may be connected to the input of the speaker amplifier 360 which may be for example a Class-D audio amplifier. An output 372 of the temperature calculation module 352 may be connected to the audio processor 354.

The audio processing system 350 may drive a multi-speaker network including a first speaker 368, a second speaker 366, and a capacitor C‴. The output 362 of the amplifier 360 may be connected to a first terminal of the capacitor C‴ and a first terminal of the first speaker 368. A second terminal of the first speaker may be connected to a ground 370. The second terminal of the capacitor C‴ may have a connection 364 to a first terminal of the second speaker. The second terminal of the second speaker 366 may be connected to a ground 370.

In operation, an audio input signal s1‴ may be input into the audio processor 354. The temperature calculation module 352 may include a circuit model of the speaker network including the first speaker 368, second speaker 366, and the capacitor C'". The temperature calculation module may have a model of the transfer function of the amplifier 360 and a circuit model of the multi speaker network including the first speaker 368, the second speaker 366 and capacitor C"'. The temperature calculation module 352 may determine a value of i1‴ and i2‴ from the voltage value of the processed signal s2"'. The temperature calculation module 352 may determine a temperature T1‴ of the voice coil of the first speaker 368 and the temperature T2‴ of the voice coil of the second speaker 366 from the estimated current values for i1‴ and i2‴. The audio processor 354 alters the amplitude, or signal energy in selective frequency regions corresponding to the speaker passbands of the first speaker 368 and the second speaker 366 in response to the temperature values T1‴ and T2‴.

The audio processor 354 may for example attenuate one or more frequencies within the speaker passband if the temperature value exceeds a predetermined threshold. Alternatively or in addition the audio processor 354 may amplify signals in selective frequency regions if the temperature value of either T1‴ or T2‴ indicates that the respective speaker voice coil temperature is low, which may for example be a temperature of less than 40 degrees Celsius, and therefore the signal may be boosted in certain frequencies without damaging the speaker. The processed output signal s2'" may be amplified by the audio speaker amplifier 360. The resulting voltage output of the amplifier v1‴ may result in a current i1‴ in the voice coil of the first speaker 368 and a current i2‴ in the voice coil of the second speaker 366. By altering the amplitude or signal energy in selective frequency bands, the audio processing system 350 may predominantly control the currents flowing through the first speaker 368 and the second speaker 366 separately. The audio processor system 350 may enable a multiway speaker system to be driven from a single amplifier 360 while maintaining audio quality and ensuring that the different speakers in a multiway speaker system are not damaged by for example overheating.

In other examples, the audio processing system may drive a multi-speaker system having three or more speakers with a cross-over network. As will be appreciated, the audio processing system may determine a voice coil temperature value for each of the speakers and independently control the current by selective frequency processing of an audio signal.

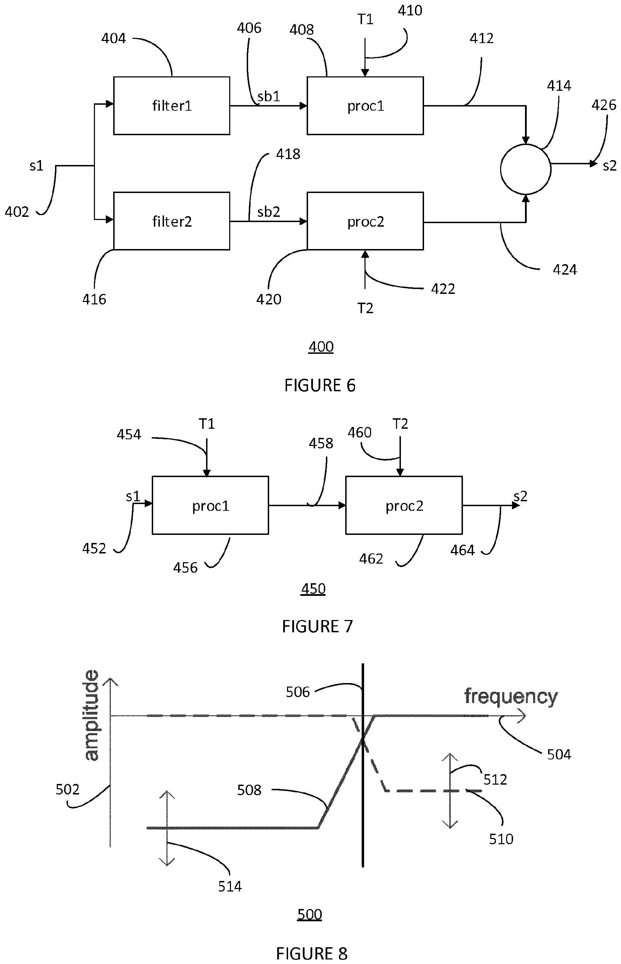

Figure 6 shows an example audio processor 400 used within the audio processing system. Audio input 402 is connected to a first filter 404 and a second filter 416. An output 406 of the first filter 404 is connected to a first processing module 408. An output 412 of the first processing module 408 is connected to a mixer 414. An output 418 of the second filter 416 is connected to the second processing module 420 and output of the second processing module 424 is connected to the mixer 414. The audio processor outputs a processed audio signal on the mixer output 426. The first processing module 408 receives a temperature value T1 on input 410 from a temperature calculation module (not shown). The second processing module 420 may receive a temperature value T2 on the input 422 from the temperature calculation module (not shown). The first filter 404 and the second filter 416 may be considered to be a filter bank. In operation the filter bank may split an input signal s1 into two subband signals sb1 and sb2. The filter bank may be tuned in such a way that the cut-off frequency is related to the crossover frequency between the respective amplifier-output-to-current transfer functions, that is to say the branch containing the first filter 404 and the first processing module 408 corresponding to the first amplifier-output-to-current transfer function, and the branch containing the second filter 416 and the second processing module 420 corresponding to the second amplifier-output-to-current transfer function. After filtering, the signal powers of the subband signals sb1 and sb2 may be modified separately by the respective processing modules 408, 420. After processing, the processed subband signals may be mixed or added resulting in an output signal s2. The processing performed by the first processing module 408, and the second processing module 420 may be for example the application of an attenuation factor, a dynamic range controller, or a further filtering operation. The operating parameters of each of the first processing module 408, and the second processing module 420 may be adapted to control the voice coil temperature T1 or T2 of a respective speaker in a multiway speaker network (not shown). For instance, if T1 exceeds a certain threshold value, more attenuation may be applied to subband signal sb1.

Figure 7 shows a further example audio processor 450 which may be used in one or more examples of the audio processing system herein described. An audio input 452 is connected to a first processing module 456 which has a temperature value input 454 connected to a temperature calculation module (not shown). The output 458 of the first processing module 456 may be connected to a second processing module 462. The second processing module 462 may have a temperature value input 460 connected to a temperature calculation module (not shown). The second processing module 462 may have an output 464. The audio processor 450 processes the input signal s1 by separate processing modules connected in series. The first processing module 456 and the second processing module 462 may receive voice coil temperature estimates, which are predicted, T1 and T2. The first processing module 456 and the second processing module 462 may process the input signals in such a way that the respective voice coil temperature is controlled by selectively modifying the signal energy. The audio processor 450 may output a processed signal s2 on the output 464 of the second processing module.

Each of the processing modules may be a filter, which may be for example a shelving filter with variable gain which may be controlled to exert the desired modification of the signal energy. For instance, the gain of the filter in the first processing module 456 may be reduced if T1 exceeds a certain threshold value.

An example of a characteristic of a shelving filter which may be used in the audio processor 450, is illustrated in figure 8. Graph 500 shows amplitude 502 on the y-axis versus frequency 504 on the x-axis. A low shelving filter characteristic is illustrated by the solid line 508. A low shelving filter may have a "shelf' at lower frequencies with variable gain, which may either boost (amplify), or attenuate the lower frequencies. At low frequencies, the low shelving filter 508 has a first "shelf', that is to say a first constant amplitude portion at an amplitude with a lower value than a second shelf at higher frequencies. A high shelving filter is illustrated by the dashed line 510. A high shelving filter has a first "shelf", that is to say a first constant amplitude portion at a higher amplitude at low frequencies than a second "shelf' at high frequencies. The crossover frequency indicated by line 506 may correspond to the crossover frequency between for example a mid-range loudspeaker and a tweeter. The cross over frequency may for example be 2 KHz. The low shelving filter may be applied to control a mid-range loudspeaker. The high shelving filter may be applied to control a tweeter. The amplitude of the first shelf of the low shelving filter 508 may be increased or decreased as indicated by line 514. The amplitude of the second shelf of the high shelving filter 510 may be increased or decreased as indicated by line 512.

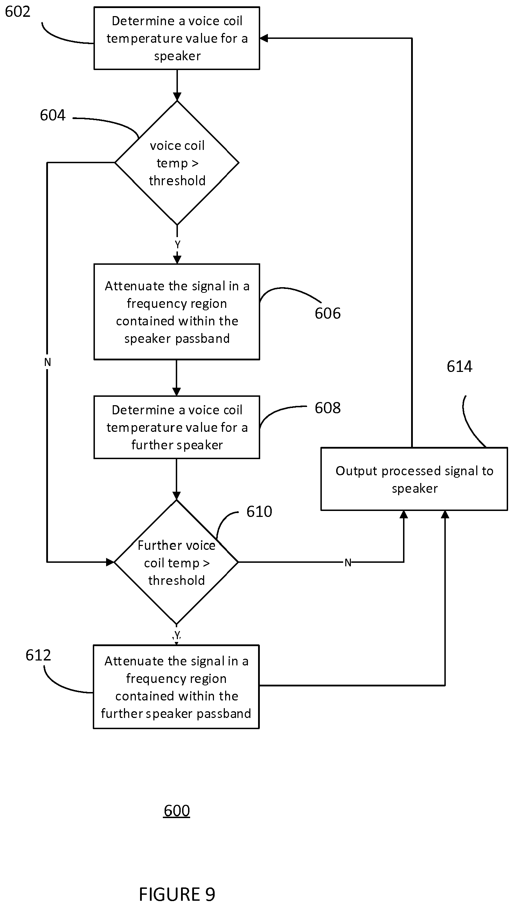

Figure 9 shows a method of audio processing for a multiway speaker system 600. In step 602 a voice coil temperature is determined for a speaker. In step 604 a comparison may be made between the voice coil temperature determined and a threshold value. If the voice coil temperature is greater than the threshold value, then the method moves to step 606 where the audio signal may be attenuated in a frequency region contained within the speaker passband. The method then moves to step 608 whereby a voice coil temperature is determined for a further speaker. In step 610 a comparison is made between the voice coil temperature for the further speaker against a threshold value which may be the same or different to that of the first speaker. Moving back to step 604 if the voice coil temperature of the first speaker is not greater than the threshold value then the method goes straight to step 610. Moving back to step 610, if the further voice coil temperature is greater than the threshold value, then the method moves to step 612, and the signal is attenuated in a frequency region contained within the further speaker passband. In step 610 if the further voice coil temperature is not greater than the threshold value, then the method moves to step 614 where the output process signal is sent to the speaker network. Following the attenuation step of 612, the method also moves to step 614. The method then returns to step 602, where the cycle repeats.

Herein is described an audio processing system for a multi-speaker system having a speaker and a further speaker coupled to the output of an amplifier is described.

The audio processing system may allow temperature control of multiple speakers using a single amplifier.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. An audio processing system (100,200) for a multi-speaker system having a speaker and a further speaker coupled to the output of an amplifier, each of the speaker and the further speaker having a respective amplifier-output-voltage-to-current transfer function comprising at least one speaker passband, the audio processing system comprising:
a temperature calculation module (202) configured to determine a first voice coil temperature value (T1) of the speaker and a second voice coil temperature value (T2) of the further speaker using a thermal loudspeaker model;
an audio processor (204) having a first input (208) configured to receive an audio signal (s1), a second input (210) coupled to the temperature calculation module and an output (212) configured to output a processed audio signal (s2) to the amplifier;
wherein the audio processor is configured to process the audio signal by selectively altering the amplitude of one or more frequencies of the audio signal within frequency regions corresponding to the speaker passbands of the speaker and the further speaker in dependence of the determined respective voice coil temperature value (T1,T2) of the speaker and the further speaker to produce the processed audio signal on the audio processor output (212).

2. The audio processing system of claim 1 wherein the temperature calculation module (302,352) is coupled to the audio processor output (212), and comprises a predictive model of the amplifier and a speaker circuit of the speaker and the further speaker, the temperature calculation module being configured to determine the first and second voice coil temperature values for the speaker and the further speaker based on the processed audio output signal.

3. The audio processing system of claim 1 wherein the temperature calculation module (202) is coupled to the audio processor first input (208) and comprises a predictive model of the amplifier and a speaker circuit of the speaker and the further speaker, the temperature calculation model being configured to determine the first and second voice coil temperature values for the speaker and the further speaker based on the audio signal.

4. The audio processing system of claim 1 further comprising the amplifier (314) having an input coupled to the audio processor output (308) and an output (328) configured to be coupled to the speaker and the further speaker, and a current sensor (312) having an input coupled to the amplifier output (328) and a current sensor output (310) coupled to a temperature calculation module input.

5. The audio processing system of claim 4 wherein the audio processor is further configured to:
generate a constant amplitude and constant frequency signal;
detect the generated constant amplitude and constant frequency signal using the current sensor;
determine an impedance of the speaker and further speaker based on an attenuation of the generated signal; and
determine the temperature value of the speaker and the further speaker based on the impedance of the speaker and the further speaker.

6. The audio processing system of any preceding claim wherein the audio processor (400) further comprises a first audio processing module (408) and a second audio processing module (420), wherein the temperature calculation module is coupled to the first audio processing module and the second audio processing module and wherein the first audio processing module is configured to respond to the first voice coil temperature value and the second audio processing module is configured to respond to the second voice coil temperature value.

7. The audio processing system of claim 6 wherein the audio processor further comprises:
a first series arrangement of a first filter (404) and the first audio processing module (408) between the audio processor input and the audio processor output, the first filter having a first filter passband overlapping the at least one speaker passband of the speaker;
a second series arrangement of a second filter (416) and the second audio processing module between the audio processor input and the audio processor output, the second filter having a second filter passband overlapping the at least one speaker passband of the further speaker; wherein
the first series arrangement is in parallel with the second series arrangement.

8. The audio processing system of claim 6 wherein the audio processor further comprises a series arrangement of the first audio processing module (456) and the second audio processing module (462).

9. The audio processing system of any preceding claim comprising the amplifier having an input coupled to the output of the audio processor and configured to receive the processed audio signal.

10. A multi-speaker system comprising the audio processing system of claim 9 and further comprising the speaker (220) and the further speaker (222) coupled to the output of the speaker amplifier.

11. A method (600) of controlling a multi-speaker system having a speaker and a further speaker coupled to the output of an amplifier, the method comprising:
determining (602, 608) a first voice coil temperature value of a speaker and a second voice coil temperature value of a further speaker using a thermal loudspeaker model, each of the speaker and further speaker having an amplifier-output-voltage-to-current transfer function comprising at least one speaker passband;
processing an audio signal by selectively altering the amplitude of one or more frequency regions of the audio signal corresponding to the speaker passbands (606, 612) of the speaker and the further speaker in dependence of the respective determined voice coil temperature value of the speaker and the further speaker;
outputting the processed audio signal to the amplifier.

12. The method of claim 11 wherein at least one of the voice coil temperature value and the further voice coil temperature value is determined from a respective one of the speaker voice coil current signal and the further speaker voice coil current signal.

13. The method of claim 12 further comprising generating at least one constant amplitude and constant frequency signal, detecting the generated signal in the speaker voice coil current signal and the further speaker voice coil current signal, determining an impedance of the speaker and the further speaker from the difference in amplitude between the generated signal and the detected signal; and determining the first ands second voice coil temperature values based on the impedance of the speaker and the further speaker.

## Patentansprüche

1. Audioverarbeitungssystem (100, 200) für ein Mehrlautsprechersystem mit einem Lautsprecher und einem weiteren Lautsprecher, an den Ausgang eines Verstärkers gekoppelt, wobei jeder des Lautsprechers und des weiteren Lautsprechers eine jeweilige Verstärkerausgangsspannungs-zu-Strom-Transferfunktion aufweist, die mindestens ein Lautsprecherdurchlassband umfasst, wobei das Audioverarbeitssystem umfasst:
ein Temperaturberechnungsmodul (202), das ausgelegt ist zum Bestimmen eines ersten Tauchspulentemperaturwerts (T1) des Lautsprechers und eines zweiten Tauchspulentemperaturwerts (T2) des weiteren Lautsprechers unter Verwendung eines thermischen Lautsprechermoduls;
einen Audioprozessor (204) mit einem ersten Eingang (208), der ausgelegt ist zum Empfangen eines Audiosignals (s1), einem zweiten Eingang (210), der an das Temperaturberechnungsmodul gekoppelt ist, und einem Ausgang (212), der ausgelegt ist zum Ausgeben eines verarbeiteten Audiosignals (s2) an den Verstärker;
wobei der Audioprozessor ausgelegt ist zum Verarbeiten des Audiosignals durch selektives Abändern der Amplitude einer oder mehrerer Frequenzen des Audiosignals innerhalb Frequenzbereichen entsprechend den Lautsprecherdurchlassbändern des Lautsprechers und des weiteren Lautsprechers in Abhängigkeit von dem bestimmten jeweiligen Tauchspulentemperaturwert (T1, T2) des Lautsprechers und des weiteren Lautsprechers zum Erzeugen des verarbeiteten Audiosignals an dem Audioprozessorausgang (212).

2. Audioverarbeitungssystem nach Anspruch 1, wobei das Temperaturberechnungsmodul (302, 352) an den Audioprozessorausgang (212) gekoppelt ist und ein prädiktives Modell des Verstärkers und einer Lautsprecherschaltung des Lautsprechers und des weiteren Lautsprechers umfasst, wobei das Temperaturberechnungsmodul ausgelegt ist zum Bestimmen des ersten und zweiten Tauchspulentemperaturwerts für den Lautsprecher und den weiteren Lautsprecher auf Basis des verarbeiteten Audioausgangssignals.

3. Audioverarbeitungssystem nach Anspruch 1, wobei das Temperaturberechnungsmodul (202) an den ersten Eingang (208) des Audioprozessors gekoppelt ist und ein prädiktives Modell des Verstärkers und einer Lautsprecherschaltung des Lautsprechers und des weiteren Lautsprechers umfasst, wobei das Temperaturberechnungsmodul ausgelegt ist zum Bestimmen des ersten und zweiten Tauchspulentemperaturwerts für den Lautsprecher und den weiteren Lautsprecher auf Basis des Audiosignals.

4. Audioverarbeitungssystem nach Anspruch 1, weiter umfassend den Verstärker (314) mit einem Eingang, der an den Audioprozessorausgang (304) gekoppelt ist, und einem Ausgang (328), der ausgelegt ist zum Gekoppeltwerden an den Lautsprecher und den weiteren Lautsprecher, und einen Stromsensor (312) mit einem Eingang, der an den Verstärkerausgang (328) gekoppelt ist, und einen Stromsensor (310), der an einen Temperaturberechnungsmoduleingang gekoppelt ist.

5. Audioverarbeitungssystem nach Anspruch 4, wobei der Audioprozessor weiter ausgelegt ist zum:
Generieren eines Signals mit konstanter Amplitude und konstanter Frequenz;
Detektieren des generierten Signals mit konstanter Amplitude und konstanter Frequenz unter Verwendung des Stromsensors;
Bestimmen einer Impedanz des Lautsprechers und des weiteren Lautsprechers auf Basis einer Dämpfung des generierten Signals; und
Bestimmen des Temperaturwerts des Lautsprechers und des weiteren Lautsprechers auf Basis der Impedanz des Lautsprechers und des weiteren Lautsprechers.

6. Audioverarbeitungssystem nach einem vorhergehenden Anspruch, wobei der Audioprozessor (400) weiter ein erstes Audioverarbeitungsmodul (408) und ein zweites Audioverarbeitungsmodul (420) umfasst, wobei das Temperaturberechnungsmodul an das erste Audioverarbeitungsmodul und das zweite Audioverarbeitungsmodul gekoppelt ist und wobei das erste Audioverarbeitungsmodul ausgelegt ist zum Reagieren auf den ersten Tauchspulentemperaturwert und das zweite Audioverarbeitungsmodul ausgelegt ist zum Reagieren auf den zweiten Tauchspulentemperaturwert.

7. Audioverarbeitungssystem nach Anspruch 6, wobei der Audioprozessor weiter umfasst:
eine erste Reihenanordnung aus einem ersten Filter (404) und dem ersten Audioverarbeitungsmodul (408) zwischen dem Audioprozessoreingang und dem Audioprozessorausgang, wobei der erste Filter ein erstes Filterdurchlassband aufweist, das das mindestens eine Lautsprecherdurchlassband des Lautsprechers überlappt;
eine zweite Reihenanordnung aus einem zweiten Filter (416) und dem zweiten Audioverarbeitungsmodul zwischen dem Audioprozessoreingang und dem Audioprozessorausgang, wobei der zweite Filter ein zweites Filterdurchlassband aufweist, das das mindestens eine Lautsprecherdurchlassband des weiteren Lautsprechers überlappt; wobei
die erste Reihenanordnung parallel mit der zweiten Reihenanordnung liegt.

8. Audioverarbeitungssystem nach Anspruch 6, wobei der Audioprozessor weiter eine Reihenanordnung aus dem ersten Audioverarbeitungsmodul (456) und dem zweiten Audioverarbeitungsmodul (462) umfasst.

9. Audioverarbeitungssystem nach einem vorhergehenden Anspruch, umfassend den Verstärker mit einem Eingang, der an den Ausgang des Audioprozessors gekoppelt und ausgelegt ist zum Empfangen des verarbeiteten Audiosignals.

10. Mehrlautsprechersystem, umfassend das Audioverarbeitungssystem nach Anspruch 9 und weiter umfassend den Lautsprecher (220) und den weiteren Lautsprecher (222), an den Ausgang des Lautsprecherverstärkers gekoppelt.

11. Verfahren (600) zum Steuern eines Mehrlautsprechersystems mit einem Lautsprecher und einem weiteren Lautsprecher, an den Ausgang eines Verstärkers gekoppelt, wobei das Verfahren umfasst:
Bestimmen (602, 608) eines ersten Tauchspulentemperaturwerts eines Lautsprechers und eines zweiten Tauchspulentemperaturwerts eines weiteren Lautsprechers unter Verwendung eines thermischen Lautsprechermodells, wobei jeder des Lautsprechers und des weiteren Lautsprechers eine Verstärkerausgangsspannungs-zuStrom-Transferfunktion, die mindestens ein Lautsprecherdurchlassband umfasst, aufweist;
Verarbeiten eines Audiosignals durch selektives Abändern der Amplitude von einem oder mehreren Frequenzgebieten des Audiosignals entsprechend den Lautsprecherdurchlassbändern (606, 612) des Lautsprechers und des weiteren Lautsprechers abhängig von dem jeweiligen bestimmten Tauchspulentemperaturwert des Lautsprechers und des weiteren Lautsprechers;
Ausgeben des verarbeiteten Audiosignals an den Verstärker.

12. Verfahren nach Anspruch 11, wobei mindestens eine des Tauchspulentemperaturwerts und des weiteren Tauchspulentemperaturwerts aus einem jeweiligen des Lautsprechertauchspulenstromsignals und des weiteren Lautsprechertauchspulenstromsignals bestimmt wird.

13. Verfahren nach Anspruch 12, weiter umfassend das Generieren mindestens eines Signals mit konstanter Amplitude und konstanter Frequenz, Detektieren des generierten Signals in dem Lautsprechertauchspulenstromsignals und dem weiteren Lautsprechertauchspulenstromsignal, Bestimmen einer Impedanz des Lautsprechers und des weiteren Lautsprechers aus der Differenz aus der Amplitudendifferenz zwischen dem generierten Signal und dem detektierten Signal; und Bestimmen des ersten und zweiten Tauchspulentemperaturwerts auf Basis der Impedanz des Lautsprechers und des weiteren Lautsprechers.

## Revendications

1. Système de traitement audio (100, 200) pour un système multi-enceintes ayant une enceinte et une autre enceinte couplées à la sortie d'un amplificateur, chacune de l'enceinte et de l'autre enceinte ayant une fonction de transfert tension-courant de sortie d'amplificateur comprenant au moins une bande passante d'enceinte, le système de traitement audio comprenant :
un module de calcul de température (202) configuré pour déterminer une première valeur de température de bobine de voix (T1) de l'enceinte et une deuxième valeur de température de bobine de voix (T2) de l'autre enceinte en utilisant un modèle de haut-parleur thermique ;
un processeur audio (204) ayant une première entrée (208) configurée pour recevoir un signal audio (s1), une deuxième entrée (210) couplée au module de calcul de température et une sortie (212) configurée pour délivrer un signal audio traité (s2) à l'amplificateur ;
le processeur audio étant configuré pour traiter le signal audio en modifiant sélectivement l'amplitude d'une ou plusieurs fréquences du signal audio dans des régions de fréquences correspondant aux bandes passantes d'enceintes de l'enceinte et de l'autre enceinte en fonction de la valeur de température de bobine de voix (T1, T2) respective déterminée de l'enceinte et de l'autre enceinte pour produire le signal audio traité sur la sortie de processeur audio (212).

2. Système de traitement audio selon la revendication 1, le module de calcul de température (302, 352) étant couplé à la sortie de processeur audio (212), et comprenant un modèle prédictif de l'amplificateur et d'un circuit d'enceintes de l'enceinte et de l'autre enceinte, le module de calcul de température étant configuré pour déterminer les première et deuxième valeurs de température de bobines de voix pour l'enceinte et l'autre enceinte sur la base du signal de sortie audio traité.

3. Système de traitement audio selon la revendication 1, le module de calcul de température (202) étant couplé à la première entrée de processeur audio (208) et comprenant un modèle prédictif de l'amplificateur et d'un circuit d'enceintes de l'enceinte et de l'autre enceinte, le module de calcul de température étant configuré pour déterminer les première et deuxième valeurs de température de bobines de voix pour l'enceinte et l'autre enceinte sur la base du signal audio.

4. Système de traitement audio selon la revendication 1, comprenant en outre l'amplificateur (314) ayant une entrée couplée à la sortie de processeur audio (308) et une sortie (328) configurée pour être couplée à l'enceinte et à l'autre enceinte, et un capteur de courant (312) ayant une entrée couplée à la sortie d'amplificateur (328) et une sortie de capteur de courant (310) couplée à une entrée de module de calcul de température.

5. Système de traitement audio selon la revendication 4, le processeur audio étant en outre configuré pour :
générer une amplitude constante et un signal de fréquence constant ;
détecter l'amplitude constante générée et un signal de fréquence constant en utilisant le capteur de courant ;
déterminer une impédance de l'enceinte et de l'autre enceinte sur la base d'une atténuation du signal généré ; et
déterminer la valeur de température de l'enceinte et de l'autre enceinte sur la base de l'impédance de l'enceinte et de l'autre enceinte.

6. Système de traitement audio selon l'une quelconque des revendications précédentes, le processeur audio (400) comprenant en outre un premier module de traitement audio (408) et un deuxième module de traitement audio (420), le module de calcul de température étant couplé au premier module de traitement audio et au deuxième module de traitement audio et, le premier module de traitement audio étant configuré pour répondre à la première valeur de température de bobine de voix et le deuxième module de traitement audio étant configuré pour répondre à la deuxième valeur de température de bobine de voix.

7. Système de traitement audio selon la revendication 6, le processeur audio comprenant en outre :
un premier agencement série d'un premier filtre (404) et du premier module de traitement audio (408) entre l'entrée de processeur audio et la sortie de processeur audio, le premier filtre ayant une première bande passante de filtre superposant l'au moins une bande passante d'enceinte de l'enceinte ;
un deuxième agencement série d'un deuxième filtre (416) et du deuxième module de traitement audio entre l'entrée de processeur audio et la sortie de processeur audio, le deuxième filtre ayant une deuxième bande passante de filtre superposant l'au moins une bande passante d'enceinte de l'autre enceinte ;
le premier agencement série étant en parallèle avec le deuxième agencement série.

8. Système de traitement audio selon la revendication 6, le processeur audio comprenant en outre un agencement série du premier module de traitement audio (456) et du deuxième module de traitement audio (462).

9. Système de traitement audio selon l'une quelconque des revendications précédentes, comprenant l'amplificateur ayant une entrée couplée à la sortie du processeur audio et configurée pour recevoir le signal audio traité.

10. Système multi-enceintes comprenant le système de traitement audio selon la revendication 9 et comprenant en outre l'enceinte (220) et l'autre enceinte (222) couplées à la sortie de l'amplificateur d'enceinte.

11. Procédé (600) de commande d'un système multi-enceintes ayant une enceinte et une autre enceintes couplées à la sortie d'un amplificateur, le procédé comprenant :
la détermination (602, 608) d'une première valeur de température de bobine de voix d'une enceinte et d'une deuxième valeur de température de bobine de voix d'une autre enceinte en utilisant un modèle de haut-parleur thermique, chacune de l'enceinte et de l'autre enceinte ayant une fonction de transfert tension-courant de sortie d'amplificateur comprenant au moins une bande passante d'enceinte ;
le traitement d'un signal audio en modifiant sélectivement l'amplitude d'une ou plusieurs régions de fréquences du signal audio correspondant aux bandes passantes d'enceintes (606, 612) de l'enceinte et de l'autre enceinte en fonction de la valeur de température de bobine de voix déterminée respective de l'enceinte et de l'autre enceinte ;
la sortie du signal audio traité vers l'amplificateur.

12. Procédé selon la revendication 11, au moins une de la valeur de température de bobine de voix et de l'autre valeur de température de bobine de voix étant déterminée à partir d'un signal respectif parmi le signal de courant de bobine de voix d'enceinte et l'autre signal de courant de bobine de voix d'enceinte.

13. Procédé selon la revendication 12, comprenant en outre la génération d'au moins une amplitude constante et d'un signal de fréquence constant, la détection du signal généré dans le signal de courant de bobine de voix d'enceinte et de l'autre signal de courant de bobine de voix d'enceinte, la détermination d'une impédance de l'enceinte et de l'autre enceinte à partir de la différence d'amplitude entre le signal généré et le signal détecté ; et la détermination des première et deuxième valeurs de température de bobines de voix sur la base de l'impédance de l'enceinte et de l'autre enceinte.
